# EUROPEAN PATENT APPLICATION

(11) **EP 1 764 425 A1**
(43) Date of publication of application: **21.03.2007**
(21) Application number: 05425644.1
(22) Date of filing: 15.09.2005
(51) Int. Cl.: C23C 14/56, C23C 14/32, C23C 14/08

(54) **Apparatus and method for producing a flexible tape for packages provided with a transparent coating**

(71) Applicant: Semico S.r.l., 50135 Lamporecchio PT (IT)
(72) Inventor: Cenci, Gettulio, 50135 Lamporecchio PT (IT); Morosi, Filippo, 51035 Lamporecchio PT (IT)
(74) Representative: Lanzoni, Luciano

(57) **Abstract**

Apparatus for producing a transparent and flexible tape for packages provided with a coating transparent to light and microwaves and obtained by a high-vacuum vapor deposition process, the apparatus comprising:
- a high-vacuum chamber (1) inside which at least a continuous, flexible and transparent tape (2) is fed to a roll (20) and moved forward up to a gathering station (13) by means of at least a process roller (3);
- at least a system for the vaporization of the material intended to form the said coating, comprising:

- a pair of horizontal electrodes (4a, 4b) spaced apart but aligned with each other in a direction perpendicular to the axis of rotation of the roller (3), the said electrodes being powered with electric negative potential;
- a crucible (5) for the material to be vaporized, located below and equidistant from said electrodes (4a, 4b) and powered with electric positive potential to allow the production of an arc (8) through the said electrodes (4a, 4b) which causes a cloud (9) of vapors of the material in the crucible (5);
- means (11) for delivering an oxidizing gas and located at a level intermediate between the process roller (3) and the electrodes (4a, 4b).

## Description

The present invention relates to an apparatus and a method for producing a tape of plastic or similar flexible material for packages, the said taper being provided with a transparent barrier or coating.

Packages of flexible and transparent plastics having very low permeability to gas and vapor are known to be increasingly in demand on the market, especially in the foodstuff and health sectors.

Actually, the gas and vapor impermeability is of fundamental importance to maintain a good quality of the packaged food stuffs, inasmuch as the exchange of oxygen, carbon dioxide or water vapors between the inside and the outside of the package may cause numerous deteriorations of the products. Moreover, the transparency of said packages to visible radiations is necessary to allow the consumers to visually inspect the nature and state of conservation of the packaged foodstuffs. The transparency to microwaves is instead necessary to allow the sterilization of the packaged sanitary products or the cooking of packaged foods.

Also known from document EP 0460.796 B1 is the possibility of obtaining a transparent barrier on a polymeric support of polyester or polyamide, for example, by a vaporization-operated metallization of Sio₂ or Si under high-vacuum, or by other systems which involve the addition of a metal such as copper, chrome, manganese, tin and zinc.

However, this known technique has various drawbacks including significant capital and running costs as well as energy requirements.

A first object of the present invention is to overcome or at least reduce the said drawbacks.

A further object is to achieve a thin coating of inorganic substances able to provide a strong adhesion to a support tape made from plastics or other suitable material.

This result has been achieved, according to the invention, by devising an apparatus and an operating process having the characteristics indicated in claims the 1 and 15, respectively. Further characteristics being set forth in the dependent claims.

The advantages obtained therefrom lie essentially in the fact that the tape thus produced exhibits a high surface hardness while maintaining its flexibility unchnaged over time even when subjected to repeated folding. Moreover, the plastic material treated with this system results fully recyclable.

These and other characteristics will be best understood by anyone skilled in the art from a reading of the following description in conjunction with the attached drawings given as possible embodiments of the invention, but not to be considered in a limitative sense, wherein:
- Fig. 1 shows schematically a first preferential embodiment of an apparatus according to the invention; and
- Fig. 2 shows a second preferential embodiment of the apparatus of Fig. 1.

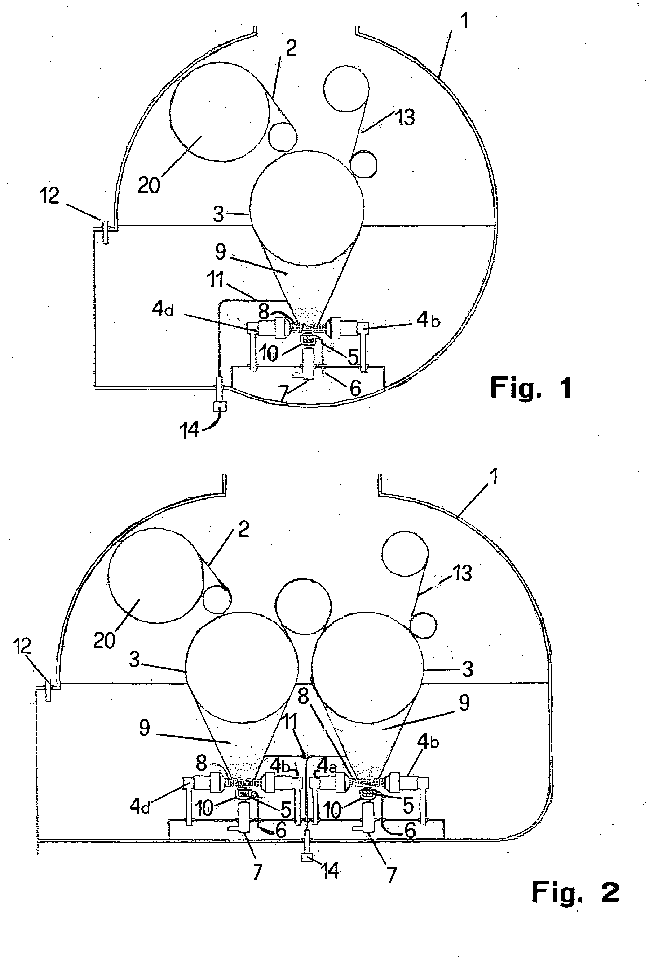

Reduced to its basic structure and reference being made to Fig. 1 of the attached drawings, an apparatus for producing a flexible tape for packages provided with a transparent coating, according to the invention, comprises:
- a high-vacuum chamber (1) within which a tape (2) of suitable flexible and transparent material (for example, plastics or of other nature) is fed from the roll (2) in the direction of arrow F up to a gathering station (13) via a rotating process roller (3) which is driven by means known per se and is provided with means, also known per se, for adjusting its rotary speed and heat-treatment conditions;
- at least a pair of electrodes (4a, 4b) which are in alignment opposite or close to each other and perpendicular to the axis of rotation of the process roller (3), the same electrodes being powered with negative electric potential;
- a crucible (5) for the material (10) to be vaporized, made from resistive material such as graphite, located below and equidistant from said electrodes (4a, 4b) and provided with means for the heating thereof via electric leads (6, 7) for example, the same crucible being at positive potential to generate an electric arc (8) with the electrodes (4a, 4b). Above the crucible (5) the vaporized material forms a cloud of vapors (9);
- means for continually adjusting the value of the current, applied between said electrodes (4a, 4b) and said crucible, by means of electronic devices for controlling the process according to a predetermined procedure;
- means in the form of a nozzle (11) disposed intermediate between the process roller (3) and the electrodes (4a, 4b) and delivering an oxidizing gas (for example, oxygen) so as to intercept the vaporized material (9) present therein;
- means for continually adjusting the quantity of said oxidizing gas to be delivered and comprising a sensor (12) (for example, a lambda probe) and a valve (14) associated with said sensor (12), wherein the sensor (12) provides for measuring the instantaneous concentration of the oxidizing gas and feeds a corresponding signal to a program processor (processor interface) which, in turn, provides for adjusting the said valve (14).

With reference to Fig. 2 of the attached drawings, the apparatus according to the invention comprises a plurality of process rollers (3) rotating about parallel axes and, accordingly, a plurality (for example, two) of vaporization systems with relevant electrodes (4a, 4b) and crucibles (5), and a plurality of nozzles (11) for the delivery of the oxidizing gas.

In this way, it is possible to vaporize the same material or various materials and to apply on each tape a coating film made up of the same material or of a combination of various materials.

More particularly and advantageously:
- the electrodes (4a, 4b) of each pair are disposed at a distance of 20-100 mm from the relevant crucible (5) and at a distance of 15-50 cm from the tape (2) to be treated;
- the crucible (5) is of cylindical or conical shape with vertical axis, and is made of graphite;
- the arc between the electrodes (4a, 4b) and the crucible (5) is produced by a metal rod (not shown in the drawing for the sake of clarity) which is at electric positive potential and is to be put in contact with one of the electrodes (4a, 4b) so as to generate a plasma above the material held in the crucible (5) and to be vaporized.

The invention also relates to a method for making a flexible tape for packages, which is provided with a protective barrier trasparent to the light and microwaves, by using an apparatus of the type above described.

The said method provides, in a high-vaccum chamber (1), for:
- vaporizing at least one type of material (for example, silicon);
- impinging against said vaporized material with an oxidizing gas such as oxygen;
- condensing at least a thus oxidized material onto a continuous tape (2) of flexible and transparent material moved continually and with regular speed, according to the amount of vaporized material, so as to form a coating film on said flexible and transparent tape (2) without solution of continuity;
- cooling the coating film thus obtained to make it resistant.

More particularly and advantageously:
- the pressure inside the chamber shall be kept constant in the range of 0.005 to 0.001 mbar;
- the feeding speed of the tape (2) shall be in the range of 0.5 to 5 m/s to ensure a minimum coating deposition;
- the intensity of electric current applied between the electrodes (4a, 4b) and the crucibles (5) shall be 50-205 A at a voltage of 20-30 V;
- each crucible shall be heated by an AC or DC current at the voltage of 5-20 V to improve the electric conduction thereof and facilitate the striking of the arc (8) between the electrodes (4a, 4b);
- the material to be vaporized can be a metal (such as Al, Mg and Cr), a metal compound, a semiconductor (such as Si), or a semiconductor compund;
- the film for the coating of tape (2) can be made of oxides of Si, Al, Mg and Cr either alone or in combination;
- the treatment will possibly interest all or part of the tape (2).

Practically, the construction details may vary in any equivalent way as far as the shape, dimensions, elements disposition, nature of the used materials are concerned, without nevertheless departing from the scope of the adopted solution idea and, thereby, remaining within the limits of the protection granted to the present patent for industrial invention.

## Claims

1. Apparatus for producing a transparent and flexible tape for packages provided with a coating transparent to light and microwaves and obtained by a high-vacuum vapor deposition process, the apparatus comprising:
- a high-vacuum chamber (1) inside which at least a continuous, flexible and transparent tape (2) is fed by a roll (20) and moved forward up to a gathering station (13) by means of at least a process roller (3);
- at least a system for the vaporization of the material intended to form the said coating, comprising:
- a pair of horizontal electrodes (4a, 4b) spaced apart but aligned with each other in a direction perpendicular to the axis of rotation of the roller (3), the said electrodes being powered with electric negative potential;
- a crucible (5) for the material to be vaporized, located below and equidistant from said electrodes (4a, 4b) and powered with electric positive potential to allow the production of an electric arc (8) through the said electrodes (4a, 4b) which causes a cloud (9) of vapors of the material in the crucible (5);
- means (11) for delivering an oxidizing gas and located at a level intermediate between the process roller (3) and the electrodes (4a, 4b).

2. Apparatus according to claim 1, **characterized in that** it comprises means for adjusting the rotary speed of the process roller 3.

3. Apparatus according to claim 1, **characterized in that** the said process roller (3) is provided with heat-treatment means.

4. Apparatus according to claim 1, **characterized in that** the elecrodes (4a, 4b) of each pair are disposed at a distance ranging from 20 to 100 millimetres from the corresponding crucible (5).

5. Apparatus according to claim 1, **characterized in that** in case of more vaporization systems the various pairs of electrodes (4a, 4b) are disposed with the electrodes being in line and/or in parallel and/or offset in parallel or in line to each other.

6. Apparatus according to claim 1, **characterized in that** it comprises a metal rod which is at positive potential and is to be put in contact with one or both of the electrodes (4a, 4b) of each pair of electrodes (4a, 4b) in order to generate an electric arc, between the electrodes (4a, 4b) and the crucible (5), and a plasma above the material held in the crucible (5) and to be vaporized.

7. Apparatus according to claim 1, **characterized in that** it comprises means for continually adjusting the value of the current applied between said electrodes (4a, 4b) and said crucible by means of electronic devices for controlling the process according to a predetermined procedure.

8. Apparatus according to claim 1, **characterized in that** the said crucible (5) is made of graphite.

9. Apparatus according to claim 8, **characterized in that** the said crucible is of cylindrical shape with vertical axis.

10. Apparatus according to claim 8, **characterized in that** the said crucible (5) has frusto conical shape with vertical axis.

11. Apparatus according to claims 8-10, **characterized in that** the said crucible (5) is provided with conductors (6, 7) for the heating thereof at low voltage.

12. Apparatus according to claim 1, **characterized in that** the said means (11) for delivering an oxidizing gas intended to impinge against the vaporized material comprise at least a nozzle which is disposed at a level intermediate between the electrodes (4a, 4b) and the process roller (3).

13. Apparatus according to claims 1-12, **characterized in that** it comprises means to continually adjust the quantity of said oxidizing gas by a sensor (12) and a valve (14) associated with said sensor (12).

14. Apparatus according to claim 13, **characterized in that** the said sensor (12) is a lambda probe for measuring the instantaneous concentration of the oxidizing gas being present and for feeding a corresponding signal to a program processor which the said valve (14) is associated with.

15. Method for making a transparent and flexible tape for packages provided with a protective barrier trasparent to light and microwaves, by means of a vaporization process in a high-vacuum chamber (1)
**characterized in that** it comprises:
- vaporizing at least one vaporizable material;
- impinging against said at least one material thus vaporized with an oxidizing gas;
- condensing the said at least one vaporizable material thus vaporized and oxidized onto one side of a continuous tape (2) of flexible material moved continually and with regular speed to achieve a flexible and trasparent coating film on the tape (2) without solution of continuity;
- cooling the tape and the coating film thus deposited onto the tape (2).

16. Method according to claim 15, **characterized in that** the pressure inside said chamber (1) is kept steady from 0.005 to 0.001 mbar.

17. Method according to claim 15, **characterized in that** the compounds to be vaporized comprise materials such as Al, Mg and Si.

18. Method according to claim 15, **characterized in that** the materials to be vaporized comprise metals such as A1.

19. Method according to claim 15, **characterized in that** the materials to be vaporized comprise semiconductors such as Si.

20. Method according to claim 15, **characterized in that** the materials to be vaporized comprise semiconductor compounds.

21. Method according to claim 15, **characterized in that** the oxidizing gas is oxygen.

22. Method according to claim 15, **characterized in that** the coating film comprises such oxides as Si, Al, Mg, Cr, alone or in combination with each other.

23. Method according to claim 15, **characterized by** carrying out one or more treatments, also repeatedly, on the tape (2).

24. Method according to claim 15, **characterized in that** the tape to be treated is of plastics or other suitable material.

25. Method according to claim 15, **characterized in that** the feeding speed of the tape (2) to be treated is in the range of 0.5 to 5 m/s to ensure the formation of a coating film of 5-100 nm.

26. Method according to claim 15, **characterized in that** each process roller (3) is heat-treated.

27. Method according to claim 15, **characterized in that** the intensity of the electric current applied between each pair of electrodes (4a, 4b) and the corresponding crucible (5) is 50-205 A at a voltage of 20-30 V.

28. Method according to claim 15, **characterized in that** each crucible (5) is heated by an AC or DC current at the voltage of 5-20 V to improve the electric conduction and facilitate the striking of the arc (8) between the electrodes (4a, 4b).

29. A transparent and flexible tape for packages provided with a coating transparent to light and microwaves which is obtained by the method according to one or more claims 15 to 28.
